# EUROPÄISCHE PATENTANMELDUNG

(11) **EP 1 271 633 A2**
(43) Veröffentlichungstag der Anmeldung: **02.01.2003**
(21) Anmeldenummer: 02090217.7
(22) Anmeldetag: 20.06.2002
(51) Int. Cl.: H01L 21/312

(54) **Verfahren zur Funktionalisierung und Passivierung der Oberfläche von Silizium-Wafern durch elektrochemisches Abscheiden dünner organischer Schichten**

(30) Priorität: 22.06.2001 DE 10130801
(71) Anmelder: Hahn-Meitner-Institut Berlin GmbH, 14109 Berlin (DE)
(72) Erfinder: Hartig, Prosper, 12555 Berlin (DE); Dittrich, Thomas, 85748 Garching (DE); Rappich, Jörg, 14197 Berlin (DE)
(74) Vertreter: Rudolph, Margit

(57) **Zusammenfassung**

Verfahren zur Funktionalisierung und Passivierung der Oberfläche von Silizium-Wafern durch elektrochemisches Abscheiden dünner organischer Schichten

Es ist ein Verfahren zum elektrochemischen Abscheiden dünner organischer Schichten auf Silizium-Wafern bekannt, das den Nachteil aufweist, daß die Siliziumoberfläche durch die ätzende Wirkung des Fluorwasserstoffs aufgeraut wird und so die ursprünglich atomar glatte Oberfläche verloren geht.

Nach dem vorliegenden Verfahren wird die Substanz zur chemischen Ätzung gegen einen sauren Elektrolyten ausgetauscht. Der Elektrolyt wird unter einem Potential gegenüber dem Silizium-Wafer gehalten, das negativ gegenüber dem Oxidationspotential der Oberfläche des Silizium-Wafers und positiv gegenüber einer (makroskopischen) Wasserstoff-Blasenbildung ist. Zu dem Elektrolyten wird die gelöste organische Verbindung zugegeben, wobei der Elektrolyt bis zum vollständigen Abscheiden der organischen Schicht im wesentlichen unter dem gleichen Potential gehalten wird.

Das Verfahren eignet sich z. B. für das Abscheiden von Diazoniumverbindungen.

## Beschreibung

Die Erfindung betrifft ein Verfahren zur Funktionalisierung und Passivierung der Oberfläche von Silizium-Wafern durch elektrochemisches Abscheiden dünner organischer Schichten nach einer Reinigungsvorbehandlung und Entfernung der Oxidschicht mittels chemischer Ätzung unter Bildung von atomar glatten Terrassen.

Mit organischen Substanzen beschichtetes kristallines Silizium ist ein interessantes Material für verschiedene technische Bereiche.

In der Halbleiterindustrie besteht z. B. großes Interesse an der Passivierung von Siliziumoberflächen, die als Grenzflächen zu Substraten oder weiteren Funktionsschichten fungieren, um die Rekombinationsrate von Ladungsträgern an diesen Grenzflächen zu senken und so die Funktionalität von Halbleiterbauelementen zu erhöhen. Als Zwischenschichten, z. B. in Heterostruktur-Solarzellen, sind organische Schichten geeignet, eine Anpassung der sogenannten Bandverbiegung herbeizuführen.

Die Möglichkeit, Siliziumoberflächen atomar glatt herstellen zu können, macht sie auch für biochemische und biotechnologische Untersuchungen interessant. So lässt sich z. B. DNA über eine organische Schicht direkt an eine Siliziumoberfläche binden. Eine Vielzahl von verschiedenen DNA-Molekülen kann so unter gleichen Bedingungen auf Silizium-Arrays bezüglich ihrer genetischen Variationen hin untersucht werden. Bei Untersuchungen an organischen Materialien mit Hilfe von Raster-Sonden-Mikroskopen können Siliziumoberflächen als Substrat dienen, an die sich die Materialien chemisch binden lassen, so daß sie auch mechanisch gegenüber der Messspitze des Raster-Sonden-Mikroskops festgelegt sind. Schließlich lässt sich Silizium als Substrat für eine Fülle von organischen Molekülen verwenden, die spezifische Reaktionen gegenüber anderen Substanzen aufweisen, womit sich spezielle Sensoren herstellen lassen.

Silizium hat den Nachteil, daß es an Luft sehr schnell oxidiert und eine amorphe Oxidschicht bildet. Die Oxidschicht muss vor einer chemischen oder elektrochemischen Abscheidung organischer Materialien entfernt werden, will man die vorteilhaften Bindungseigenschaften atomar glatter Siliziumoberflächen nutzen.

Bekannt ist die chemische Abscheidung von organischen Verbindungen, die in Lösungsmitteln vorliegen. Die Abscheidung muss unter Schutzgasatmosphäre erfolgen und das Lösungsmittel muss wasserfrei sein. Beides erfordert einen hohen technischen Aufwand.

Aus Allongue et al, Organic Monolayers on Si(111) by Electrochemical Method, Electrochimica Acta, Vol. 23 (1998), Nos 19-20, pp. 2791-2798 ist auch ein Verfahren bekannt, mit dem organische Verbindungen elektrochemisch an Silizium gebunden werden. Die Abscheidung erfolgt in einem wässrigen Elektrolyten, der zu 2% Fluorwasserstoff (HF) enthält. Und zwar wird ein n-dotierter Silizium-Wafer nach einer Reinigungsvorbehandlung mit Trichlorethylen, Aceton und Methanol in 40%igem Ammoniumfluorid (NH₄F) geätzt. Als Elektrolyt, gegen den anschließend das NH₄F ausgetauscht wird, dient 0,1 molare Schwefelsäure, der 2% HF zugesetzt wurde. Der Elektrolyt enthält außerdem eine organische Diazoniumverbindung, aus der auf der Oberfläche des Siliziums Monoschichten von Phenylgruppen abgeschieden werden. Der Fluorwasserstoff schützt den Silizium-Wafer vor Oxidation, indem an der Siliziumoberfläche Wasserstoffatome an die freien Valenzen des Siliziums gebunden werden. Unter dem Wassereinfluss entstehendes Oxid wird vom Fluorwasserstoff aufgelöst.

Das Verfahren hat den Nachteil, daß die Siliziumoberfläche durch die ätzende Wirkung des Fluorwasserstoffs aufgeraut wird und so die ursprünglich atomar glatte Oberfläche verloren geht. Die gewollten definierten Oberflächenbedingungen gehen damit verloren. Außerdem führt der Ätzangriff an Stufen des Siliziums zum Unterätzen und Ablösen der organischen Schicht. dies verschlechtert die Kontrolle der Abscheidung von Monolagen.

Der Erfindung liegt die Aufgabe zugrunde, ein Verfahren der eingangs genannten Art anzugeben, mit dem sich organische Materialien auf Siliziumoberflächen abscheiden lassen ohne dass die glatte Oberflächenstruktur verändert wird.

Erfindungsgemäß wird die Aufgabe gelöst durch die Merkmale des Anspruchs 1. Zweckmäßige Ausgestaltungen sind Gegenstand der Unteransprüche.

Danach wird die Substanz zur chemischen Ätzung gegen einen sauren Elektrolyten ausgetauscht, der Elektrolyt unter einem Potential gegenüber dem Silizium-Wafer gehalten, das negativ gegenüber dem Oxidationspotential der Oberfläche des Silizium-Wafers und positiv gegenüber einer (makroskopischen) Wasserstoff-Blasenbildung ist, und es wird zu dem Elektrolyten die gelöste organische Verbindung zugegeben, wobei der Elektrolyt bis zum vollständigen Abscheiden der organischen Schicht im wesentlichen unter dem gleichen Potential gehalten wird. Die Zugabe des Elektrolyten, die Einstellung des Potentials und die Zugabe der gelösten organischen Verbindung erfolgen zweckmäßig zeitlich nacheinander. Dabei sollte zum Lösen der organischen Verbindung die gleiche Substanz benutzt werden, die auch als Elektrolyt benutzt wird.

Als geeigneter Elektrolyt hat sich z. B. 0,01 molare Schwefelsäure erwiesen. Außerdem hat sich ein Potential von -1,2 V gegen Gold in 0,01 molarer Schwefelsäure als etwa der Bereich herausgestellt, bei dem keine Oxidbildung, aber auch noch keine Wasserstoff-Blasenbildung auftritt, die den Abscheideprozess stören würde.

Das Verfahren hat den Vorteil, dass durch das Arbeiten mit einem sauren Elektrolyten unter negativem Potential auch ohne Zugabe von ätzenden Substanzen die Oxidation verhindert wird.

Die Erfindung soll nachstehend anhand eines Ausführungsbeispiels näher erläutert werden. In den zugehörigen Zeichnungen zeigen
- Fig. 1: den Aufbau einer Anlage zur Durchführung des erfindungsgemäßen Verfahrens und
- Fig. 2: den Verlauf des Stromes im Elektrolyten, die Photospannung und die Photolumineszenz einer Probe während des Abscheideprozesses.

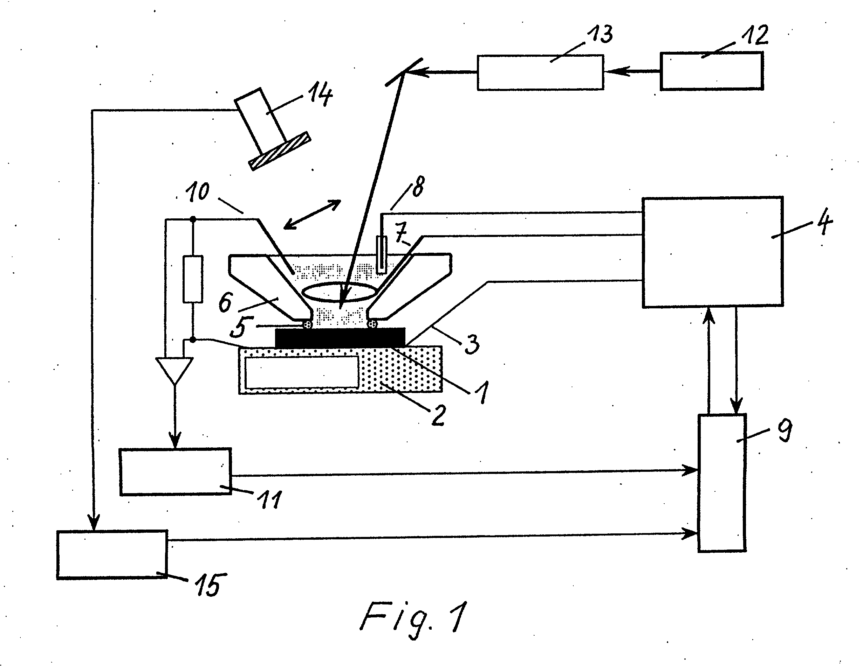

Fig. 1 zeigt eine bekannte Anordnung zur elektrochemischen Abscheidung auf einer Probenoberfläche. Benutzt wird eine Probe **1** - ein Silizium-Wafer aus p-dotiertem (111)-Silizium mit einer Leitfähigkeit von ca. 1 - 10 Ωcm, der zuvor ca. 100 nm tief thermisch oxidiert wurde. Die Probe **1** wird 20 Minuten in einem Aceton-Ultraschallbad (Pro Analysi) gereinigt, anschließend 12 Minuten in 2%igem Fluorwasserstoff (HF - Selectipur) geätzt und mit Reinstwasser (tridestilled) gespült, darauf 10 Minuten in Carowsche Säure (H₂O₂, 30%ig, H₂SO₄, 96%ig, Selectipur, frisch angesetzt) eingelegt, wieder mit Reinstwasser gespült und mit Stickstoff getrocknet.

Gegebenenfalls wird das thermische Oxidieren und das anschließende Ätzen ein- oder mehrfach wiederholt, um eine atomar glatte (111)-Oberfläche des Siliziums zu erhalten.

Für einen widerstandsarmen, definierten Rückseitenkontakt wird die Oxidschicht an einer Kontaktstelle mit 2%igem HF weggeätzt und anschließend Indiumgallium (InGa) gleichmäßig aufgetragen, das in einer pastösen Form vorliegt.

Die so vorbereitete Probe **1** wird auf einen Metallprobenteller **2** aufgelegt, der mit einer Arbeitselektrode **3** eines Potentiostaten **4** verbunden ist. Auf die Probe **1** wird über einen Vitonring **5** eine Teflonzelle **6** auf die Probe **1** gestellt und mit einer Gegenelektrode **7** und einer Referenzelektrode **8** des Potentiostaten **4** versehen. Für die Gegenelektrode **7** und die Referenzelektrode **8** wird Golddraht (Reinheit 99,99%) benutzt. Vitonring **5,** Teflonzelle **6,** Gegenelektrode **7** und Referenzelektrode **8** wurden zuvor in Carowscher Säure und/oder Salpetersäure (HNO₃) oder mit Reinstwasser gereinigt und gespült. In die Teflonzelle **6** wird darauf 40%iges Ammoniumfluorid (NH₄F) eingebracht und mindestens 4 Minuten belassen. Anschließend wird das NH₄F durch 0,01 molare Schwefelsäure (H₂SO₄) ersetzt. Nach dem Einfüllen wird mit dem Potentiostaten **4** ein kathodisches Potential von ca. -1,2 V zwischen Referenzelektrode **8** und Arbeitselektrode **3** angelegt, das potentiostatisch gehalten wird. Das Potential verhindert die Oxidation des Siliziums, ist aber nicht in einem Potentialbereich, in dem es zur Blasenbildung von Wasserstoff (H) im Elektrolyten käme. Zu der Schwefelsäure wird nun ein etwa gleiches Volumen 0,01 molare Schwefelsäure (H₂SO₄), zu der eine organische Diazoniumverbindung, z. B. p-Nitrobenzoldiazoniumtetrafluoroborate, hinzugegeben. Die Konzentration der organischen Diazoniumverbindung im gesamten Lösungsvolumen beträgt 5 mMol. Nach der Abscheidung von Nitrobenzol-Molekülen, die bis zu einigen Minuten dauern kann, kann die Lösung entfernt und die Probe entnommen werden. Eine Trocknung der Probe **1** erfolgt mit Stickstoff.

Durch die Einstellung des Potentials vor der Zugabe der Diazoniumverbindung werden definierte Potentialverhältnisse geschaffen, so daß dann nach der Zugabe der Diazoniumverbindung eine Potentialänderung in den oxidierenden Bereich ausgeschlossen ist, zumal für die Diazoniumverbindung ein Lösungsmittel mit dem gleichen pH-Wert benutzt wird. Der Strom- und Potentialverlauf ist so außerdem leicht zu überwachen.

Während des Abscheideprozesses werden in situ die angelegte Spannung, der Strom i im Elektrolyten und zweckmäßig außerdem die Photospannung U_{PV} und die Photolumineszenz I_{PL} gemessen.

Die Spannung wird vom Potentiostaten **4** zwischen der Referenzelektrode **8** und der Probe **1** eingestellt. Die Messung des Stromes i erfolgt über den Potentiostaten **4,** der zur Aufzeichnung der Messwerte mit einem Personalcomputer verbunden ist.

Zur Messung der Photolumineszenz I_{PL} wird die Probe **1** durch einen von einem Laser **12** gepumpten Farbstofflaser **13** angeregt. Als geeignet hat sich eine Wellenlänge von λ = 500 nm bei einer Strahlungsintensität von 130 µJ/cm² und kurzzeitigen Pulsen von ca. 1 nsec erwiesen. Die Photolumineszenz I_{PL} wird mit einem Strahlungsdetektor 14 erfasst und mittels eines Oszillographen **15** gemessen, der wiederum mit dem Personalcomputer **9** verbunden ist.

Die Messung der Photospannung U_{PV} erfolgt an einer in den Elektrolyten getauchten Messelektrode **10** gegenüber dem Potential der Probe **1** mittels eines Oszillographen **11,** der ebenfalls mit dem Personalcomputer **9** verbunden ist.

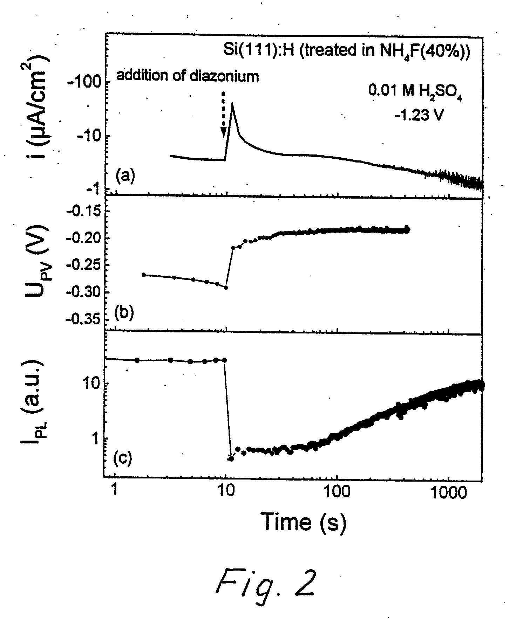

Fig. 2 zeigt den Verlauf der gemessenen Größen während der Abscheidephase. Bei der Zugabe der Diazoniumverbindung kommt es zu einem spürbaren Stromanstieg. Mit zunehmender Anbindung von Nitrobenzol-Molekülen an freie Valenzen des Siliziums wird die Elektronenbewegung durch diese organische Schicht behindert und der Strom nimmt demzufolge ab.

Die Photospannung U_{PV} sinkt augenblicklich um ungefähr 100 mV.

Die Photolumineszenz I_{PL} sinkt bei Zugabe der Diazoniumverbindung drastisch, steigt aber dann - offensichtlich nach einem Ordnungsvorgang der Nitrobenzol-Moleküle - wieder fast auf den ursprünglichen Wert an.

Die hier beispielhaft angegebene Anordnung für die Verfahrensdurchführung kann insbesondere bei industrieller Anwendung natürlich durch eine Durchflusszelle ersetzt werden.

### Bezugszeichenliste

- 1: Probe
- 2: Metallprobenteller
- 3: Arbeitselektrode
- 4: Potentiostat
- 5: Vitonring
- 6: Teflonzelle
- 7: Gegenelektrode
- 8: Referenzelektrode
- 9: Personalcomputer
- 10: Messelektrode
- 11: Oszillograph
- 12: Laser
- 13: Farbstofflaser
- 14: Strahlungsdetektor
- 15: Oszillograph

- i: Strom
- U_{PV}: Photospannung
- I_{PL}: Photolumineszenz

## Patentansprüche

1. Verfahren zur Funktionalisierung und Passivierung der Oberfläche von Silizium-Wafern durch elektrochemisches Abscheiden dünner organischer Schichten nach einer Reinigungsvorbehandlung und Entfernung der Oxidschicht mittels chemischer Ätzung unter Bildung von atomar glatten Terrassen,
**dadurch gekennzeichnet, dass**
die Substanz zur chemischen Ätzung gegen einen sauren Elektrolyten ausgetauscht wird, der Elektrolyt unter einem Potential gegenüber dem Silizium-Wafer gehalten wird, das negativ gegenüber dem Oxidationspotential der Oberfläche des Silizium-Wafers und positiv gegenüber einer (makroskopischen) Wasserstoff-Blasenbildung ist, und dass zu dem Elektrolyten die gelöste organische Verbindung zugegeben wird, wobei der Elektrolyt bis zum vollständigen Abscheiden der organischen Schicht im wesentlichen unter dem gleichen Potential gehalten wird.

2. Verfahren nach Anspruch 1,
**dadurch gekennzeichnet, dass**
die Zugabe des Elektrolyten, die Potentialeinstellung und die Zugabe der gelösten organischen Verbindung zeitlich nacheinander erfolgen.

3. Verfahren nach Anspruch 1 oder 2,
**dadurch gekennzeichnet, dass**
zum Lösen der organischen Verbindung die gleiche Substanz dient, die auch als Elektrolyt benutzt wird.

4. Verfahren nach einem der Ansprüche 1 bis 3,
**dadurch gekennzeichnet, dass**
als Elektrolyt 0,01 molare Schwefelsäure benutzt wird.

5. Verfahren nach einem der vorhergehenden Ansprüche,
**dadurch gekennzeichnet, dass**
der Elektrolyt unter einem Potential von etwa -1,2 V gegenüber einer Goldelektrode gehalten wird.

6. Verfahren nach einem der vorhergehenden Ansprüche,
**dadurch gekennzeichnet, dass**
(111)-Silizium mit einer Leitfähigkeit von 1 - 10 Ωcm verwendet wird.

7. Verfahren nach einem der vorhergehenden Ansprüche,
**dadurch gekennzeichnet, dass**
p-dotiertes Silizium verwendet wird.

8. Verfahren nach einem der vorhergehenden Ansprüche,
**dadurch gekennzeichnet,daß**
zur Abscheidung ein Potentiostat benutzt wird.

9. Verfahren nach einem der Ansprüche 1 bis 7,
**dadurch gekennzeichnet,daß**
zur Abscheidung eine Durchflusszelle benutzt wird.
